# EUROPEAN PATENT SPECIFICATION

(11) **EP 0 694 811 B1**
(45) Date of publication and mention of the grant of the patent: **24.11.1999**
(21) Application number: 94202199.9
(22) Date of filing: 28.07.1994
(51) Int. Cl.: G03C 8/28, G03F 7/07

(54) **Image receiving material for use in a silver salt diffusion transfer process**
Bildempfangsmaterial zur Verwendung in einem Silbersalz-Diffusionsübertragungsverfahren
Matériau récepteur d'image pour utilisation dans un procédé de diffusion transfert de sel d'argent

(43) Date of publication of application: 31.01.1996
(73) Proprietor: AGFA-GEVAERT N.V., 2640 Mortsel (BE)
(72) Inventor: De Keyzer, René, Septestraat 27, B-2640 Mortsel (BE)

(56) References cited:
- EP-A- 0 546 598
- US-A- 3 345 169
- US-A- 3 424 580
- US-A- 3 647 440
- US-A- 4 304 835
- DATABASE WPI Section PQ, Week 9346, Derwent Publications Ltd., London, GB; Class P83, AN 93-362254 & JP-A-5 265 162 (MITSUBISHI PAPER MILLS LTD) 15 October 1993

## Description

### 1. Field of the invention.

The present invention relates to a silver salt diffusion transfer material and to a method for obtaining an image or a lithographic printing plate therewith.

### 2. Background of the invention.

The principle of the silver complex diffusion transfer process (hereinafter referred to as DTR process) is well known from the description in U.S. Pat. NO. 2,352,014 and in the book "Photographic Silver Halide Diffusion Processes" by André Rott and Edith Weyde - The Focal Press - London and New York, (1972).

In the DTR process, the silver complex is imagewise transferred by diffusion from a silver halide emulsion layer to an image receptive layer and transformed therein into a silver image generally in the presence of physical development nuclei. For this purpose, the imagewise exposed silver halide emulsion layer is arranged so as to be in contact with or is brought into contact with the image receptive layer in the presence of a developing agent and a solvent for the silver halide, thereby to convert the unexposed silver halide into a soluble silver complex. In the exposed areas of the silver halide emulsion layer, the silver halide is developed into silver which is insoluble and, hence, cannot diffuse. In the unexposed areas of the silver halide emulsion layer, the silver halide is converted into a soluble silver complex and is transferred to an image receptive layer wherein the silver complex forms a silver image generally in the presence of physical development nuclei.

The DTR process can be utilized in a wide field such as reproduction of documents, making of printing plates, preparation of block copies, and instant photography.

Particularly in reproducing documents or preparing block copies, an imaging element having a silver halide emulsion layer is brought into close contact with a positive material having an image receptive layer in a DTR processing solution generally containing a silver-complexing agent, thereby to form a silver image in the receptive layer of the positive material. The silver image in these cases is required to be in such a state that it is pure black or bluish black in color and sufficiently high in density. It is also important that the silver image be high in contrast and sharpness, excellent in image reproducibility, and preferably high in transfer speed.

As mentioned above the DTR-process can also be used for making lithographic printing plates. A DTR-image bearing material can be used as a planographic printing plate wherein the DTR-silver image areas form the water-repellant ink-receptive areas on a water-receptive ink-repellant surface. The DTR-image can be formed in the image-receiving layer of a sheet or web material which is a separate element with respect to the photographic silver halide emulsion material (a so-called two-sheet DTR element) disclosed in e.g. DE-A-2.346.378 or in the image-receiving layer of a so-called single-support-element, also called mono-sheet element, which contains at least one photographic silver halide emulsion layer integral with an image-receiving layer in water permeable relationship therewith. It is the latter mono-sheet version which is preferred for the preparation of offset printing plates by the DTR method.

As for other printing plates it is required that the printing plates obtained according to the DTR-process have a high printing endurance, good ink acceptance in the printing areas and no ink acceptance in the non-printing areas (no staining). It is furthermore desirable that the number of copies that have to be disposed of because of ink acceptance in the non-printing areas (so called toning) during start-up of the printing process is limited. With respect to these requirements the state of the transferred silver i.e. the silver formed in the image-receiving layer plays a very important role. Parameters that are known to control the state of the transferred silver are e.g. the rate of development of the exposed silver halide (chemical development), rate of dissolution of the non-exposed silver halide by the silver halide solvent(s), rate of diffusion of the silver halide complexes, rate of development of the silver halide complexes in the image receiving layer (physical development) etc.. Although other factors such as for example the plate construction have an influence on the aforementioned parameters the type of physical development nuclei influences most of the mentioned parameters to a large extent.

Preferred physical development nuclei for use in an image accepting layer are sulfides of heavy metals e.g. sulfides of cobalt, lead, nickel, platinum and silver. Especially suitable physical development nuclei are palladium sulfide nuclei. Heavy metals, preferably silver, gold, platinum, palladium, and mercury in colloidal form are also used .

The use of said sulfides as physical development nuclei in an image accepting layer has a number of disadvantages. The synthesis of these compounds is hazardous, the coating layer of said compounds may have an obnoxious odour and sulfide salts in a layer in water permeable relationship with a silver halide containing layer may generate fog in said emulsion layer resulting in an image with white spots in the image areas or in a printing plate having non-printing spots in the printing areas.

The use of heavy metals in colloidal form as physical development nuclei in an image accepting layer has also a number of disadvantages. Aside from their high cost price, their reactivity as physical development nuclei in an image accepting layer is (too) low and their colloidal dispersions have a clear tendency to coagulation, causing a clustering of the colloids and a further lowering of their reactivity.

US-A 4 304 835 discloses a receiving element for use in an additive color photographic diffusion transfer process which comprises a transparent support carrying an additive color screen and a layer comprising noble metal silver precipitating nuclei.

US-A 3 345 169 discloses that photographic nuclei for use in the diffusion transfer process having improved stability are prepared by treating silver precipitating nuclei with an ionic compound comprising a noble metal selected from the class consisting of palladium, platinum , gold and mixtures thereof.

### 3. Summary of the invention

It is an object of the present invention to provide a DTR-material for obtaining images of high density, high contrast and sharpness and excellent in image quality with a lowered cost price and/or according to an ecological production process.

It is an object of the present invention to provide a DTR-material for making a lithographic printing plate with excellent lithographic printing properties with a lowered cost price and/or according to an ecological production process.

It is an object of the present invention to provide a DTR-process with a lowered cost price and/or more ecological for obtaining an image of high density, high contrast and sharpness and excellent in image quality.

It is an object of the present invention to provide a DTR-process with a lowered cost price and/or more ecological for making a lithographic printing plate with excellent printing properties.

Further objects of the present invention will become clear from the description hereinafter.

According to the present invention there is provided an image receiving material comprising on a support a receiving layer containing physical development nuclei consisting of a homogeneous solid solution of at least two metals, one of them having an E° value of at least 0.75 V, the other one(s) having an E° value of at least - 1 V, wherein said physical development nuclei are obtainable by radiolysis or photolysis of the ions of said at least two metals.

According to the present invention there is provided a lithographic printing plate precursor comprising on a support a silver halide emulsion layer and an image receiving layer containing physical development nuclei consisting of a substantially homogeneous solid solution of at least two metals, one of them having an E° value of at least 0.75 V, the other one(s) having an E° value of at least - 1 V.

According to the present invention there is provided a method for obtaining an image according to the DTR-process using the above defined image receiving material.

According to the present invention there is provided a method for obtaining a lithographic printing plate according to the DTR-process using the above defined image receiving material or the above defined lithographic printing plate precursor.

### 4. Detailed description of the invention.

It has been found that when a DTR-process is carried out using an image receiving material comprising on a support a receiving layer containing physical development nuclei consisting of a substantially homogeneous solid solution of at least two metals, one of them having an E° value of at least 0.75 V, the other one(s) having an E° value of at least - 1 V the quality of the image is improved. More precisely the density in the non-image areas is substantially decreased while the maximum density in the image areas is only slightly decreased so that an image with improved contrast and sharpness is obtained. Furthermore when the DTR-material is used as a lithographic printing plate a printing plate with a better ink acceptance is obtained.

JP-A-52-65 162 discloses a permeating, image receiving material for DTR characterized in that said material comprises physical nuclei having a **structure** in which to the surface of one reduced metal nucleus another reduced metal was attached.

US-A-4,304,835 discloses the use as physical development nuclei of noble metal nuclei which can include the noble metal alloyed with another metal. However, in said patent is not disclosed that said noble metal forms a substantially homogeneous solution with said other metal.

From these disclosures there is nothing that suggest that nuclei containing a substantially **homogeneous solid solution** of at least two metals would be suitable as physical development nuclei in an image receiving layer;

The composition of the nuclei is determined by High Resolution Electron Miccroscopy and nanoprobe Energy Dispersive X-Ray Fluorescence (HREM-EDX) with a PHILIPS CM 20-EDAX as described by M. Yao et al. in Conference Abstracts, p. T-048 of "6^{th} Internat. Symp. on Small Particles and Inorganic Clusters", The Univ. of Chicago, Illinois, U.S.A., September 15-22, 1992.

The E° value of a metal is the standard reduction potential at 25°C and 101.325 kPa with respect to the standard hydrogen electrode. A list of these values is given in e.a. "CRC Handbook of Chemistry and Physics" - 74^{th} Ed. - CRC Press - London.

At least one of the metals comprised in the nuclei has an E° value of at least 0.75 V, preferably of at least 0.85 V, more preferably of at least 0.95 V. Such metals are e.g. Pd, Pt, Au.

The E° value of the other(s) metals comprised in the nuclei is at least -1 V, preferably at least - 0.70 V, more preferably at least - 0.40 V. Such metals are e.g. Ni, Cu, Co, Ag.

The molar ratio in the nuclei between the metal having the highest E° value and (the sum of) the other metal(s) ranges from 10:1 to 1:100, more preferably from 5:1 to 1:50, most preferably from 2:1 to 1:20.

Preferably the physical development nuclei according to the invention contained in said receiving layer have a number average diameter less than 10nm, more preferably less than 8nm, most preferably less than 6.5nm.

Although the size of the nuclei above is expressed by a diameter this does not imply that the nuclei are necessarily spherical. By diameter is meant the diameter of a sphere having the same volume as the nucleus so that the size of nuclei of a variety of shapes can be characterized by the same parameter.

The physical development nuclei according to the present invention may be prepared according to known procedures as described by J. Belloni et al., Nouv. J. Chimie, **6**, 507 (1982), M. Mostafavi et al., Radiat. Phys. Chem., **34**, 605 (1989) and O. Platzer, J. Phys. Chem., **96**, 2334 (1992). For example an aqueous solution containing between 10⁻⁴ mole/l and 10⁻³ mole/l of a water soluble salt of the metal with the highest E° value, between 10⁻³ mole/l and 10⁻² mole/l of (a) water soluble salt(s) of the metal(s) with the lower E° value, between 10⁻¹ mole/l and 1 mole/l of an electron scavenger such as isopropanol or HCO₂Na, between 20 g/l and 2 g/l of a water soluble polymer such as polyvinyl alcohol or polyacrylic acid, at a pH range from 2 to 12 and at a temperature range from 15°C to 60°C was subjected to radiolysis by ionizing radiation i.a. X-rays or to photolysis i.a. at 254 nm at a dose ranging from 0.3 Mrad to 10 Mrad/10⁻³ mole/l of dissolved metal salt.

The obtained nuclei are preferably stabilized using a stabilizer. Suitable stabilizers are large organic molecules that readily adsorb to the surface of the nuclei. Examples are heterocyclic compounds containing a water solubilizing group such as -COOH, -SO₃H or -SO₂H e.g. tetrazoles containing a water solubilizing group as described in e.g. EP-A 218752.

The amount of nuclei used in the image receiving layer is preferably between 0.02 mg/m² and 20 mg/m², more preferably between 0.04 mg/m² and 10 mg/m², most preferably between 0.08 mg/m² and 5 mg/m² .

According to the present invention the image receiving layer may be contained in a separate image receiving material or may be in water permeable relationship with a light sensitive silver halide emulsion layer in an imaging element.

Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or complexed silver ions.

According to a first embodiment of the present invention an image is obtained by information-wise exposing an imaging element comprising on a support e.g. a paper support or organic resin support a silver halide emulsion layer and subsequently developing said information-wise exposed imaging element in the presence of developing agent(s) and silver halide solvent(s) whilst in contact with an image receiving material comprising on a support a layer containing physical development nuclei according to the invention.

The support of the image receiving material may be opaque or transparent, e.g. a paper support or resin support. Said support may also be a hydrophilic support e.g. a metal support e.g. aluminum or a support provided with a hydrophilic layer as disclosed in DE-A-2.346.378. In the latter case the obtained silver image may be used in a lithographic printing process.

The image receiving layer comprises for best imaging results the physical development nuclei according to the present invention in the presence of a protective hydrophilic colloid, e.g. gelatin and/or colloidal silica, polyvinyl alcohol etc., the coverage of binder being preferably in the range of 0.4 to 1.5 g/m².

The image-receiving element may contain in operative contact with the development nuclei thioether compounds, e.g. those described in DE-P 1,124,354, in US-P 4,013,471 and 4,072,526, and in EP-A 026,520.

Most of the DTR-positive materials now available on the market comprises two or even three layers on the side of the support that contains an image receiving layer . Such materials normally contain on top of a nuclei containing layer a layer which itself preferably contains no nuclei and mainly serves to ensure good contact between the negative and positive material during transfer. Preferably, such top layer comprises a matting agent as are disclosed in e.g. EP-A 92202602.6.

The transfer behaviour of the complexed silver largely depends on the thickness of the image-receiving layer and upperlying layers and on the kind of binding agent or the mixture of binding agents used in said layers. In order to obtain a sharp image with high spectral density the reduction of the silver salts diffusing into the image receiving layer must take place rapidly before lateral diffusion becomes substantial. For this reason the sum of the coverage of the hydrophilic colloids contained in said image receiving layer and said top layer is preferably less than 2 g/m² and most preferably not more than 1.8 g/m² and the coverage of the hydrophilic colloids contained in said top layer is preferably less than 0.45 g/m².

The sum of the coverage of the hydrophilic colloids contained in the top layers of the image-receiving element and the imaging element is preferably not more than 0.80 g/m².

According to a particular embodiment the nuclei containing layer is present on a nuclei-free waterpermeable underlying undercoat layer or undercoat layer system comprising a hydrophilic colloid and having preferably a coverage in the range of 0.05 to 1 g/m² of hydrophilic colloid

The undercoat optionally incorporates substances that improve the image quality, e.g. incorporates a substance improving the image-tone or the whiteness of the image background. For example, the undercoat may contain a fluorescent substance, silver complexing agent(s) and/or development inhibitor releasing compounds known for improving image sharpness.

According to a special embodiment the image-receiving layer is applied on an undercoat playing the role of a timing layer in association with an acidic layer serving for the neutralization of alkali of the image-receiving layer. By the timing layer the time before neutralization occurs is established, at least in part, by the time it takes for the alkaline processing composition to penetrate through the timing layer. Materials suitable for neutralizing layers and timing layers are disclosed in Research Disclosure July 1974, item 12331 and July 1975, item 13525.

In the image-receiving layer and/or in said top layer and/or in the undercoat layer gelatin is used preferably as hydrophilic colloid. In the image-receiving layer gelatin is present preferably for at least 60 % by weight and is optionally used in conjunction with an other hydrophilic colloid, e.g. polyvinyl alcohol, cellulose derivatives, preferably carboxymethyl cellulose, dextran, gallactomannans, alginic acid derivatives, e.g. alginic acid sodium salt and/or watersoluble polyacrylamides. Said other hydrophilic colloid may be used also in the top layer for at most 10 % by weight and in the undercoat in an amount lower than the gelatin content.

The image-receiving layer and/or a hydrophilic colloid layer in water-permeable relationship therewith may comprise a silver halide developing agent and/or silver halide solvent, e.g. sodium thiosulphate in an amount of approximately 0.1 g/m² to approximately 4 g/m².

The image-receiving layer or a hydrophilic colloid layer in water-permeable relationship therewith may comprise colloidal silica.

In at least one of the layers of the present image-receiving material substances can be contained, which play a role in the determination of the colour tone of the diffusion transfer silver image. Substances providing a neutral colour tone are called black-toning agents, e.g. as described in GB A 561,875 and BE A 502,525.

According to a preferred embodiment the processing liquid that will be described in detail below and/or the image-receiving material contains at least one image toning agent. In said case the image toning agent(s) may gradually transfer by diffusion from said image-receiving element into the processing liquid and keep therein the concentration of said agents almost steady. In practice such can be realized by using the silver image toning agents in a coverage in the range from 1 mg/m² to 20 mg/m² in a hydrophilic waterpermeable colloid layer.

A survey of suitable toning agents is given in the above mentioned book of André Rott and Edith Weyde, p. 61-65, preference being given to 1-phenyl-1H-tetrazole-5-thiol, also called 1-phenyl-5-mercapto-tetrazole, tautomeric structures and derivatives thereof.

Still further toning agents suitable for use in accordance with the preferred embodiment of the present invention are the toning agents described in EP-A 218752, 208346, 218753, 546599 and US-P 4,683189.

According to a practical embodiment in the image-receiving element the development nuclei containing layer and/or hydrophilic colloid layer in waterpermeable relationship therewith or a back layer at the side of the support opposite to that carrying the image receiving layer contains at least part of the silver image toning agents. Such procedure results actually in automatic replenishment of toning agent in the processing liquid. The same applies at least partially for the replenishment of the developing agent(s) and silver halide complexing agent(s).

When applying an optical brightening agent in the present image-receiving material preference is given to an optical brightening agent that is inherently by its structure resistant to diffusion or is made resistant to diffusion by use in conjunction with another substance wherein it is dissolved or whereto it is adsorbed .

The hydrophilic colloid comprising layers of the present image-receiving material and imaging material may have been hardened to achieve enhanced mechanical strength. Appropriate hardening agents for hardening the natural and/or synthetic hydrophilic colloid binding agents in the image-receiving layer include e.g. formaldehyde, glyoxal, mucochloric acid, and chrome alum. Hardening can also be effected by incorporating a hardener precursor in said layers, the hardening of the hydrophilic colloid therein being triggered by the treatment with the alkaline processing liquid. Other suitable hardening agents for hardening the hydrophilic colloid binding agents in the image-receiving layer are vinylsulphonyl hardeners, e.g. as described in Research Disclosure 22,507 of Jan. 1983.

The image-receiving material can be used in conjunction with any type of photographic silver halide emulsion material suited for use in diffusion transfer reversal processing. The silver halide emulsion material may contain more than one silver halide emulsion layer.

In the imaging material in connection with the present invention, the photosensitive silver halide emulsion layer can be coated from any photosensitive silver halide emulsion comprising a hydrophilic colloid binder. Preferably, the coverage of hydrophilic colloid contained in said layer is not more than 3.5 g/m², more preferably not more than 2.4 g/m². The weight ratio of hydrophilic colloid binder to silver halide expressed as equivalent amount of silver nitrate to binder is preferably in the range of 3:1 to 1:3 .

The photosensitive silver halide used in the present invention may be any type of photographic silver halide emulsion material suited for use in diffusion transfer reversal processing, preference being given to silver halide emulsion layers the silver halide of which is mainly silver chloride because of its relatively easy complexing with thiosulphate ions. The silver halide grains can have any size or shape and may be prepared by any technique known in the art, e.g. by single-jet or double jet precipitation.

The average size of the silver halide grains may range from 0.10 to 0.70 µm , preferably from 0.25 to 0.45 µm.

Preferably during the precipitation stage Iridium and/or Rhodium containing compounds or a mixture of both are added. The concentration of these added compounds ranges from 10⁻⁸ to 10⁻³ mole per mole of AgNO₃, preferably between 0.5∗10⁻⁷ and 10⁻⁵ mole per mole of AgNO₃.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

The spectral photosensitivity of the silver halide can be adjusted by proper spectral sensitization by means of the usual mono- or polymethine dyes such as acidic or basic cyanines, hemicyanines, oxonols, hemioxonols, styryl dyes or others, also tri-or polynuclear methine dyes e.g. rhodacyanines or neocyanines. Such spectral sensitizers have been described by e.g. F.M. HAMER in "The Cyanine Dyes and Related Compounds" (1964) Interscience Publishers, John Wiley & Sons, New York.

The silver halide emulsions may contain the usual stabilizers Suitable stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable stabilizers are i.a. heterocyclic mercapto compounds e.g. phenylmercaptotetrazole, quaternary benzothiazole derivatives and benzotriazole.

The silver halide emulsions may further contain either or not in combination with one or more developing agents pH controlling ingredients, and other ingredients such as antifogging agents, development accelerators, wetting agents, and hardening agents for gelatin.

The silver halide emulsion layer may comprise light-screening dyes that absorb scattering light and thus promote the image sharpness and, as a consequence thereof, the sharpness of the final printed copy. Light-absorbing dyes that can be used as light-screening dyes have been described in i.a. US-P 4,092,168, 4,311,787, DE-A 2,453,217 and GB-A 1,907,440. More details about the composition, preparation and coating of silver halide emulsions can be found in e.g. Product Licensing Index, Vol. 92, December 1971, publication 9232, p. 107-109.

As an interesting variant in the DTR-process the silver halide emulsion may consist of a first light-sensitive silver halide emulsion in which a normal latent image is formed upon image-wise exposure and a second silver halide emulsion whose speed is so low that no or almost no latent image is formed therein. When the low-speed silver halide emulsion and the light-sensitive silver halide emulsion are coated to form different layers, the resulting emulsion layers are arranged in DTR-processing in such a way that the low-speed emulsion is remotest from the image-receiving layer. It is also possible to coat one single layer comprising a mixture of both types of emulsion.

Thanks to the combination of light-sensitive and low-speed emulsions a silver image having an enhanced contrast can be obtained.

As the sensitivity of the low speed emulsion must be low enough to be inert in the photo-exposure, no second ripening or after-ripening thereof is applied.

The low-speed emulsion may be a pure silver chloride emulsion or an emulsion of mixed silver halides comprising silver chloride e.g. a silver chlorobromide or chlorobromoiodide emulsion. However, the low-speed emulsion is preferably a silver chloride emulsion for the greater part. Preferably a fine-grain silver chloride having a particle size in the range of 50 to 500 nm is used.

In case a mixture of low-speed emulsion and of imaging emulsion is coated to form one single layer, the amount of low-speed emulsion may vary within wide limits. Favourable results can be obtained when the ratio of low-speed silver chloride-containing emulsion to image-forming emulsion, expressed in parts by weight of silver nitrate, ranges from 10:1 to 1:1.

Apart from negative-working silver halide emulsions that are preferred for their high light-sensitivity, use can be made also of direct-positive silver halide emulsions that produce a positive silver image.

For instance, direct-positive silver halide emulsions that mainly forms an internal image as described in e.g. EP-A 365,926 and US-P 3,062,651 may be employed. Alternatively, prefogged direct-positive silver halide emulsions with internal or, more preferably, with external electron traps as disclosed in EP-A 94201899 and EP-A 481,562 are also suitable for use in connection with the present invention.

The silver halide emulsion coated side of the photographic material can be provided with a top layer that contains hydrophilic colloids that form a waterpermeable layer. Such top layer is usually free of gelatin. Its nature is such that it does not inhibit or restrain the diffusion transfer of the complexed silver but acts e.g. as an anti-stress layer. Appropriate hydrophilic binding agents for such top layer are e.g. methyl cellulose, the sodium salt of carboxymethyl cellulose, hydroxyethyl cellulose, hydroxyethyl starch, hydroxypropyl starch, sodium alginate, gum tragacanth, starch, polyvinyl alcohol, polyacrylic acid, polyacrylamide, poly-N-vinyl pyrrolidinone, polyoxyethylene, and copoly(methylvinylether/maleic acid). The thickness of this layer depends on the nature of the colloid used and the required mechanical strength. Such layer if present may be transferred at least partially to the image-receiving layer without deleterious action on the image formation.

It is preferred that the sum of the coverage of the hydrophilic colloids contained in said top layer and the emulsion layer is not more than 3.5 g/m², more preferred not more than 2.5 g/m².

The imaging element of the present embodiment may contain other additional layers comprising a hydrophilic colloid in waterpermeable relationship with the silver halide emulsion layer. Preferably, the total sum of the coverage of the hydrophilic colloids comprised in the photosensitive layer and in all other layers of the imaging material comprising a hydrophilic colloid and being in waterpermeable contact with the photosensitive layer is not more than 8.5 g/m², more preferably not more than 6.5 g/m².

It is especially advantageous to include a base-layer between the support and the photosensitive silver halide emulsion layer. Preferably, the sum of the coverage of the hydrophilic colloids contained in said base layer, the top layer, that is essentially free from silver halide emulsion and and the emulsion layer is not more than 6 g/m², more preferably not more than 5.5 g/m². In a preferred embodiment of the present invention said base-layer serves as an antihalation layer so that the reflectance of the support containing said antihalation layer is not more than 25% and preferably not more than 15%. This layer can therefore contain the same light-absorbing dyes as described above for the emulsion layer; as alternative finely divided carbon black can be used for the same antihalation purposes as described in US-P 2,327,828. Alternatively the support it self may be selected such that it can serve as antihalation means as described in e.g. US-P 4,165,237. On the other hand, in order to gain sensitivity, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

The hydrophilic colloid binder, which is comprised in the various layers of the imaging material, is usually gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.. The nature of the binder is such that the amount of liquid taken up by the imaging element when soaked for 1 min. in a 0.1 N aqueous solution of NaOH is preferably between 3.5 ml and 7 ml for 1 g binder.

The support of the imaging material may be opaque or transparent, e.g. a paper support or resin support.

In a preferred embodiment in connection with the present invention a backing layer is provided at the non-light sensitive side of the support. This layer which can serve as anti-curl layer can contain i.a. matting agents e.g. silica particles, lubricants, antistatic agents, light absorbing dyes, opacifying agents, e.g. titanium oxide and the usual ingredients like hardeners and wetting agents. The backing layer can consist of one single layer or a double layer pack.

Processing of the information-wise exposed imaging element whilst in contact with the receiving material in accordance with the DTR process includes development of the exposed silver halide in the emulsion layer of the photosensitive element, the complexing of residual undeveloped silver halide and the diffusion transfer of the silver complexes into the image-receiving material wherein physical development takes place.

The developing agent or a mixture of developing agents can be incorporated into the alkaline processing solution and/or into the imaging material. When incorporated into the photosensitive element, the developing agent(s) can be present in the silver halide emulsion layer or is (are) preferably present in a hydrophilic colloid layer in water-permeable relationship therewith, e.g. in the anti-halation layer adjacent to the silver halide emulsion layer of the photosensitive element. In case the developing agent or a mixture of developing agents is in its total contained in the photosensitive element, the processing solution is merely an aqueous alkaline solution that initiates and activates the development.

Suitable developing agents for the exposed silver halide are e.g. hydroquinone-type and 1-phenyl-3-pyrazolidone-type developing agents as well as p-monomethylaminophenol. Preferably used is a combination of a hydroquinone-type and 1-phenyl-3-pyrazolidone-type developing agent whereby the latter is preferably incorporated in one of the layers comprised on the support of the imaging material. A preferred class of 1-phenyl-3-pyrazolidone-type developing agents is disclosed in EP-A 498968.

The silver halide solvent, preferably sodium or ammonium thiosulphate, may be supplied from the non-light-sensitive image-receiving element as mentioned above, but it is normally at least partly already present in the alkaline processing solution. When present in the alkaline processing solution, the amount of silver halide solvent is in the range of e.g. 10 g/l to 50 g/l.

Preferred alkaline substances are inorganic alkali e.g. sodium hydroxide, sodium or potassium carbonate, sodium phosphate, sodium borate or alkanolamines or mixtures thereof. Preferably used alkanolamines are tertiary alkanolamines e.g. those described in EP-A 397925, 397926, 397927, 398435 and US-P 4,632,896. A combination of alkanolamines having both a pKₐ above or below 9 or a combination of alkanolamines whereof at least one has a pKₐ above 9 and another having a pKₐ of 9 or less may also be used as disclosed in the Japanese patent applications laid open to the public numbers 73949/61, 73953/61, 169841/61, 212670/60, 73950/61, 73952/61, 102644/61, 226647/63, 229453/63, US-P 4,362,811, 4,568,634 etc.. The concentration of these alkanolamines is preferably from 0.1 mol/l to 0.9 mol/l.

The alkaline processing solution usually contains preserving agents e.g. sodium sulphite, thickening agents e.g. hydroxyethylcellulose and carboxymethylcellulose, fog-inhibiting agents such as potassium bromide, black-toning agents especially heterocyclic mercapto compounds, detergents etc..

The DTR-process is normally carried out at a temperature in the range of 10°C to 35°C.

The pH of the processing solution is preferably in the range of 9 to 14, more preferably in the range of 10 to 13.

The present invention also provides an imaging element for obtaining a lithographic printing plate according to the DTR-process. Thus an imaging element is provided comprising on a support a silver halide emulsion layer and an image receiving layer containing physical development nuclei according to the invention. Suitable silver halide emulsions for use in accordance with this embodiment are those described above. To obtain good printing properties it is preferred that the image receiving layer is free of binder or contains hydrophilic binder in an amount not more than 30% by weight. When the amount of binder is larger than 30% the physical development nuclei will be imbedded in the binder matrix so that no or little silver is formed on the surface of the image receiving layer. As a consequence the silver image areas will not accept ink.

Suitable silver complexing agents also called silver halide solvents for use in connection with this embodiment are e.g. thiosulphate or thiocyanate in an amount ranging from 5 g to 20 g per liter. Other interesting silver halide complexing agents are e.g. sulphite, amines, 2-mercaptobenzoic acid, cyclic imide compounds such as e.g. uracil, 5,5-dialkylhydantoins, alkyl sulfones and oxazolidones.

Further silver halide solvents for use in connection with the present embodiment are alkanolamines. Said alkanolamines may be present in the alkaline processing liquid in a concentration preferably between 0.1% and 5% by weight. However part or all of the alkanolamine can be present in one or more layers of the imaging element.

Still other preferred further silver halide solvents for use in connection with the present embodiment are thioethers, preferably di- or poly-thioethers as disclosed in e.g. US-P-4.960.683 and EP-A 554,585.

Still further suitable silver halide solvents are meso-ionic compounds, preferably 1,2,4-triazolium-3-thiolates.

Combinations of different silver halide solvents can be used and it is also possible to incorporate at least one silver halide solvent into a suitable layer of the imaging element and to add at least one other silver halide solvent to the developing or activating solution. Preferably they are comprised in the alkaline processing liquid.

In connection with this embodiment two layer arrangements can be used for obtaining an imaging element suitable for making a lithographic printing plate according to the DTR-process. According to a first arrangement a support e.g. paper or an organic resin support is provided in the order given with a photosensitive silver halide emulsion layer and the image receiving layer of the present invention, said photosensitive layer being in water permeable relationship with said image receiving layer. The imaging element preferably also contains a base layer between the support and the silver halide emulsion layer serving as an anti-halation layer such as the anti-halation layer described above. After information-wise exposure and development according to the DTR-process using a processing liquid as described above but with the appropiate silver halide solvents a silver image is obtained in the image receiving layer. After this development step the imaging element is preferably guided through a neutralization liquid to reduce the alkaline pH of the surface of the developed imaging element. The neutralization liquid contains buffer ions, e.g. phosphate buffer or citrate buffer to establish in said liquid a pH value ranging from 5.0 to 7.0. The neutralization solution can further contain bactericides, e.g. phenol, thymol or 5-bromo-5-nitro-1,3-dioxan as described in EP 0,150,517. Finally the neutralization solution can contain wetting agents, preferably compouds containing perfluorinated alkyl groups.

To improve the differentiation between the hydrophobic silver image and the hydrophilic background the alkaline processing liquid and/or neutralization liquid preferably contain one or more hydrophobizing agents, e.g. those described in US-P-3,776,728, and US-P-4,563,410. Preferred hydrophobizing agents are mercapto-1,3,4-thiadiazoles as described in DE-A 1,228,927 and in US-P 4,563,410, 2-mercapto-5-alkyl-oxa-3,4-diazole and long chain (at least 5 carbon atoms) alkyl substituted mercaptotetrazoles. Particularly preferred compounds are 5-n-heptyl-2-mercapto-1,3,4,-oxadiazol and 3-mercapto-4-acetamido-5-n-heptyl-1,2,4-triazole.

According to the second arrangement an imaging element comprises in the order given on a hydrophilic surface of a support (i) an image receiving layer containing physical development nuclei in accordance with the present invention and (ii) a photosensitive silver halide emulsion layer, said photosensitive layer being in water permeable relationship with said image receiving layer. To obtain a lithographic plate by means of the DTR-process said imaging element may be imaged using an information-wise exposure followed by a development step in the presence of development agent(s) and silver halide solvent(s) as described above so that a silver image is formed in the physical development nuclei layer. Subsequently the imaging element is treated to remove the layer(s) on top of the image receiving layer, preferably by rinsing the imaging element with water, thereby exposing the imaged surface of the support by uncovering said silver image formed in said image receiving layer. Finally the hydrophobic character of the silver image is preferably improved using a finishing liquid comprising hydrophobizing agents as described above.

The hydrophilic surface of a support can be a hardened hydrophilic layer, containing a hydrophilic synthetic homopolymer or copolymer and being hardened with a hydrolyzed tetraalkyl orthosilicate crosslinking agent coated on a flexible hydrophobic base.

More preferably an aluminum support is used as a hydrophilic base.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally post-treating of the foil. Preferably the aluminum foil has a roughness with a CLA value between 0.2 and 1.5 µm, an anodization layer with a thickness between 0.4 and 2.0 µm and is post-treated with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

Electrochemical graining can be conducted in a hydrochloric and/or nitric acid containing electrolyte solution using an alternating or direct current. Other aqueous solutions that can be used in the electrochemical graining are e.g. acids like HCl, HNO₃, H₂SO₂, H₃PO₄, that if desired, contain additionally one or more corrosion inhibitors such as Al(NO₃)₃, AlCl₃, boric acid, chromic acid, sulfates, chlorides, nitrates, monoamines, diamines, aldehydes, phosphates, H₂O₂.

Electrochemical graining in connection with the present invention can be performed using single-phase and three-phase alternating current. The voltage applied to the aluminum plate is preferably 10-35 V. A current density of 3-150 Amp/dm² is employed for 5-240 seconds. The temperature of the electrolytic graining solution may vary from 5-50°C. Electrochemical graining is carried out preferably with an alternating current from 10 Hz to 300 Hz.

The roughening is preferably preceded by a degreasing treatment mainly for removing fatty substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

Suitable acids for use in the aqueous etch solution are preferably inorganic acids and most preferably strong acids. The total amount of acid in the aqueous etch solution is preferably at least 150g/l. The duration of chemical etching is preferably between 3s and 5min.

After roughening and optional chemical etching the aluminum foil is anodized which may be carried out as follows.

An electric current is passed through the grained aluminum foil immersed as an anode in a solution containing sulfuric acid, phosphoric acid, oxalic acid, chromic acid or organic acids such as sulfamic, benzosulfonic acid, or mixtures thereof. An electrolyte concentration from 1 to 70 % by weight can be used within a temperature range from 0-70°C. The anodic current density may vary from 1-50 A/dm² and a voltage within the range 1-100 V to obtain an anodized film weight of 1-8 g/m² Al₂O₃.H₂O. The anodized aluminum foil may subsequently be rinsed with demineralised water within a temperature range of 10-80°C.

After the anodizing step a posttreatment such as sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminum". Different types of sealing of the porous anodized aluminum surface exist.

A preferred posttreatment is performed by treating a grained and anodized aluminum support with an aqueous solution containing a bicarbonate as disclosed in EP-A 567178.

Preferably each of the above described steps is separated by a rinsing step to avoid contamination of the liquid used in a particular step with that of the preceding step.

To facilate the removal of the silver halide emulsion layer(s) an intermediate layer comprising a hydrophilic non-proteinic film forming polymer e.g. polyvinyl alcohol as disclosed in EP-A 410,500 or water swellable polymer beads e.g. polymethyl methacrylate beads as disclosed in EP-A-0 483 415 or mixtures thereof may be included between the nuclei containing layer and silver halide emulsion layer. This intermediate layer may also include anti-halation substances so that said layer may also serve as an anti-halation layer during exposure of the imaging element.

According to the present embodiment for obtaining a lithographic printing plate the silver halide emulsion contained in the DTR element may be orthochromatically sensitized with a conventional cyanine or merocyanine dye so that said DTR element can be exposed on a process camera using an ordinary light source, e.g. tungsten light.

According to the present embodiment the imaging element can also be used as recording materials for phototype-setting and image-setting devices which employ laser beams as their output energy source.

DTR imaging elements suited for exposure by helium-neon laser (HeNe) or light emitting diode (LED), both devices emitting in the red region of the visual spectrum, according to the present invention may be prepared using an appropriate sensitized silver halide emulsion as disclosed in e.g. US-P 4,501,811 and Japanese Unexamined Patent Publication (Kokai) Nos. 71055/84 and 75838/85.

On the other hand semiconductor lasers, also called laserdiodes, can be used in connection with the present invention by sensitizing the silver halide emulsion to wavelengths above 700nm using spectral sensitizers as disclosed in e.g. EP 423 399 and US-P-4.784.933.

The present invention will now be illustrated by the following examples without however limiting it thereto. All parts are by weight unless otherwise specified.

### EXAMPLE 1 (Comparative example)

### Preparation of the coating solutions 1 to 13.

A comparitive coating solution containing PdS physical development nuclei **1** was prepared as follows.

| | | |
|---|---|---|
| Solution A (20°C) | (NH₄)₂PdCl₄ | 1.74g |
| | polyvinyl alcohol (1% solution in water) | 20ml |
| | water | 380ml |
| Solution B (20°C) | Na₂S.9H₂O | 1.61g |
| | polyvinyl alcohol (1% solution in water) | 20ml |
| | water | 380ml |
| Solution C (20°C) | polyvinyl alcohol (1% solution in water) | 40ml |
| | water | 760ml |

Solution A and B were simultaneously added to solution C at a rate of 100ml/min. whilst stirring solution C at 400rpm. To remove the excess sulphide the obtained mixture was dialysed using a hollow fiber dialyser having a surface of 1.5m² and a molecular cut-off of 8000. The solution containing the PdS-nuclei was pumped through the dialyser with a delivery of 400ml/min. and water flows around the fibers with a delivery of 400ml/min. The solution was brought to a conductivety of 0.5mS and the pH was kept between 7.2 and 7.8.

About 23% of the nuclei have a diameter larger than 4.5nm while the average diameter is 3.9nm.

Another comparative coating solution containing PdS physical development nuclei **2** was prepared similar to the above procedure with the exception that 3.23g of Na₂S.9H₂O was added to solution C.

About only 2% of the nuclei have a diameter more than 4.5nm while the average diameter is 1.8nm.

The coating solutions containing metal physical development nuclei **3** to **11** were prepared as follows.

An aqueous solution containing between 10⁻⁴ mole/l and 10⁻³ mole/l of (a) water soluble salt(s) of (a) metal(s), an electron scavenger, a water soluble polymer, at a pH of 11 and at a temperature of 25°C was subjected to radiolysis at a dose ranging from 0.3 Mrad to 6. More details are given in table **1**.

**Table 1**

| Nr. | Precursor (mmole/l) | E.C.^{a)} | Pol.^{b)} | Dose (Mrad) |
|---|---|---|---|---|
| 3 | NiSO₄ (5.0) | F | P.A.A. | 5.8 |
| 4 | H₂PtCl₆ (1.0) | I | P.A.A. | 1 |
| 5 | NiSO₄ (5.0) H₂PtCL₆ (0.5) | F | P.A.A. | 5.8 |
| 6 | NiSO₄ (5.0) K₂PtCI₆ (0.5) | F | P.A.A. | 5.8 |
| 7 | HAuCl₄ (1.0) | I | P.A.A. | 0.96 |
| 8 | Ag₂SO₄ (1.0) | I | P.A.A. | 0.32 |
| 9 | CuSO₄ (1.0) | I | P.V.A. | 0.64 |
| 10 | CuSO₄ (0.5) HAuCl₄ (0.5) | I | P.V.A. | 0.8 |
| 11 | Ag₂SO₄ (0.5) HAuCl₄ (0.5) | I | P.A.A. | 0.62 |

| | | | | |
|---|---|---|---|---|
| Remarks a) E.C. : Electron scavenger is either isopropanol (I) in a concentration of 0,2 mole/l or HCO₂Na (F) in a concentration of 0,5 mole/l. | | | | |
| b) Pol. : The used polymer is either polyvinyl alcohol (P.V.A.) in a concentration of 5 g/l or polyacrylic acid (P.A.A.) in a concentration of 15 g/l. | | | | |

### Preparation of image-receiving material P1 to P6

6 subbed polyethylene terephthalate film support were coated at both sides at a dry coverage of 1.77 g/m² with image-receiving layers containing respectively the physical development nuclei **1** to **6** dispersed in gelatin. These layers were applied by slide hopper coating so that 2.85∗10⁻⁶ mole of nuclei/m² were in an undermost coating of 1.22 g gelatin/m² and a top layer was provided of 0.55 g gelatin/m².

### Preparation of imaging material N1

This imaging material was prepared analogously to the negative working light sensitive material of the Example 1 of EP-A 546.598.

| | |
|---|---|
| Hydroxyethylcellulose (g) | 2 |
| EDTA (g) | 2 |
| Na₂SO₃ (anhydrous) (g) | 45 |
| Na₂S₂0₃ (anhydrous) (g) | 14 |
| KBr (g) | 0.5 |
| 1-Phenyl-5-mercapto-tetrazole (g) | 0.08 |
| 1-(3,4 dichlorophenyl)-1-H-tetrazole-5-thiol (g) | 0.04 |
| DMEA (ml) | 30 |
| MDEA (ml) | 35 |
| Water up to | 1 litre |
| pH | 11.4 |
| EDTA = ethylenediaminetetraacetic acid tetrasodium salt DMEA = dimethylethanolamine MDEA = methyldiethanolamine | |

6 strips of the photographic materials were exposed through a sensitometric wedge in a contact exposure apparatus operating with a light source having a colour temperature of 3200 K. The exposed photographic materials were pre-moistened with the processing liquid, the contact time with said liquid being 6 seconds before being pressed together respectively with the image-receiving materials P1 to P6 as defined above. The transfer processor employed was a COPYPROOF (registered trade name of AGFA-GEVAERT N.V.) type CP 380. The transfers were carried out at a processing temperature of 22 °C and at a transfer contact times of 60 seconds.

The obtained test wedge prints in the image-receiving materials were evaluated with regard to minimum and maximum transmission density. All wedge prints were measured on a densitometer MACBETH (registered trade name) type IR 924 behind visual filter, having following wavelength (nm)/optical density (D) characteristics : 700 nm / D = 0; 600 nm / D = 0.2; 500 nm / D = 1.25; 420 nm / D = 3.0.

The transmission density measurement proceeded according to American National Standard for Photography (Sensitometry) ANSI PH2.19-1986.

### Evaluation:

The results listed in table 2 give the Dₘₐₓ and Dₘᵢₙ obtained in the diverse image receiving materials as a function of these image receiving materials, being different by the applied coating of physical developing nuclei.

**Table 2**

| Pos | Dₘₐₓ | Dₘᵢₙ |
|---|---|---|
| P₁ | 3.28 | 0.14 |
| P₂ | 3.27 | 0.06 |
| P₃ | 0.19 | 0.02 |
| P₄ | 0.81 | 0.03 |
| P₅ | 2.82 | 0.02 |
| P₆ | 2.39 | 0.03 |

The image receiving materials P1 and P4 (comparative image receiving materials) give images with a higher Dₘᵢₙ than the image receiving materials P5 and P6 (image receiving materials according to the invention). The Dₘₐₓ is only slightly higher with P1 and P2 and clearly lower with P3 and P4 than with P5 and P6, so that the image receiving materials P1 to P4 gives images with less contrast and brilliancy than the image receiving materials P5 and P6.

### EXAMPLE II (Comparative example)

### Preparation of the silver halide emulsion coating solution.

A silver chlorobromide emulsion composed of 98.2% of chloride and 1.8% of bromide was prepared by the double jet precipitation method. The average silver halide grain size was 0.4µm (diameter of a sphere with equivalent volume) and contained Rhodium ions as internal dopant. The emulsion was orthochromatically sensitized and stabilized by 1-phenyl-5-mercapto-tetrazole.

A base layer coating solution was prepared having the following composition:

| | |
|---|---|
| gelatin | 5.5% |
| carbon black | 0.76% |
| silica particles (5µm) | 1.6% |

### Preparation of the imaging element:

The silver halide emulsion coating solution was coated simultaneously with the base layer coating solution by means of the cascade coating technique to a polyethylene terephthalate support provided with a pack of two backing layers such that the base layer coating was coated directly to the side of the support opposite to the side containing said backing layers. The silver halide emulsion layer was coated such that the silver halide coverage expressed as AgNO₃ was 1.5g/m² and the gelatin content was 1.5g/m². The silver halide emulsion layer further contained 0.15g/m² of 1-phenyl-4,4'-dimethyl-3-pyrazolidone and 0.25g/m² of hydroquinone. The base layer was coated such that the amount of gelatin in the coated layer was 3g/m².

The layer nearest to the support of the backing layer pack contained 0.3 g/m² of gelatin and 0.5 g/m² of the antistatic agent co(tetraallyloxyethane / methacrylate / acrylic acid-K-salt) polymer. The second backing layer contained 4 g/m² of gelatin, 0.15 g/m² of a matting agent consisting of transparent spherical polymeric beads of 3 micron average diameter according to EP-A-080,225, 0.05 g/m² of hardening agent triacrylformal and 0.021 g/m² of wetting agent F₁₅C₇-COONH₄.

Six thus obtained elements were dried and subjected to a temperature of 40°C for 5 days and then the silver halide emulsion layers were overcoated with a layer containing respectively the physical development nuclei **2** and **7** to **11** at 3.0∗10⁻⁶ mole/m², hydroquinone at 0.4g/m² and formaldehyde at 100mg/m².

The following processing solutions were prepared :

| Activator solution | |
|---|---|
| sodium hydroxide (g) | 30 |
| sodium sulphite anh. (g) | 35 |
| potassium thiocyanate (g) | 20 |
| 2-mercapto-5-n.heptyl-oxa-3,4-diazole (mg) | 150 |
| water to make | 1 l |

| Neutralization solution | |
|---|---|
| citric acid | 10 g |
| sodium citrate | 35 g |
| cysteine | 1 g |
| sodium sulphite anh. | 5 g |
| phenol | 50 mg |
| water to make | 1 l |

| Dampening solution | |
|---|---|
| water | 880 ml |
| citric acid | 6 g |
| boric acid | 8.4 g |
| sodium sulphate anh. | 25 g |
| ethyleneglycol | 100 g |
| colloidal silica | 28 g |

The above described imaging elements were image-wise exposed and processed with the above described activator for 10 seconds at 30°C, subsequently neutralized at 25 °C with the neutralization solution described above and dried.

The printing plates thus prepared were mounted on the same offset printing machine HEIDELBERG GTO-52, marketed by Heidelberg, A.G., Germany, equipped with a DAHLGREN " 3-roll " dampening system, and were used for printing under identical conditions. The above mentioned dampening solution was used at a 3 % concentration in an aqueous solution containing 10 % isopropanol as fountain solution. The ink used was VAN SON RUBBERBASE RB 2329, marketed by Van Son, Royal Dutch Ink Factories, Hilversum, The Netherlands. A compressible rubber blanket was used.

### Evaluation:

The results listed in table **3** give the gradient, ink acceptance and print quality obtained with the diverse printing plates as a function of the different coatings of physical developing nuclei applied in the preparation of the corresponding imaging element.

**Table 3**

| Coating | G25/75^{a} | I.A.^{b} | P.Q₁₀^{c} | P.Q₅₀^{c} |
|---|---|---|---|---|
| **2** | 3.43 | 25 | 4 | 0 |
| **7** | 1.37 | > 1000 | 10 | 10 |
| **8** | 1.59 | > 1000 | 10 | 10 |
| **9** | 0.92 | > 1000 | 10 | 10 |
| **10** | 3.42 | 15 | 2 | 0 |
| **11** | 2.85 | 20 | 3 | 0 |

| | | | | |
|---|---|---|---|---|
| **Remarks** a) G25/75 : the gradient of the sensitometric curve of the printing plate between the points 25% above the minimum density and 25% below the maximum density | | | | |
| b) Ink acceptance (I.A.): the number of copies that had to be disposed of at the start of the printing process because of poor ink acceptance in the non-printing areas. | | | | |
| c) P.Q₁₀ and P.Q₅₀: the visually observed quality of the 10^{th}, respectively the 50^{th} obtained copy on a scale from 0 to 10. A lower value indicates a better copy, where 0 stands for a perfect copy, 1 to 3 for a very good to a good copy and 10 stands for a totally unacceptable copy. | | | | |

It was found that with printing plates obtained from imaging elements prepared by applying the physical developing nuclei containing coatings **2**, **7** - **9** (comparative printing plates) a poorer ink acceptance and in most cases worse copies are obtained than by using printing plates obtained from imaging elements prepared by applying the physical developing nuclei containing coatings **10** or **11** (printing plates according to the invention). The gradient of these printing plates is about 3, what is a very good compromise between sharpness (high gradient) and exposure latitude (low gradient). Printing runs of more than 5000 copies could be made with the printing plates according to the invention.

## Claims

1. An image receiving material comprising on a support a receiving layer containing physical development nuclei consisting of a substantially homogeneous solid solution of at least two metals, one of them having an E° value of at least 0.75 V, the other one(s) having an E° value of at least - 1 V, wherein said physical development nuclei are obtainable by radiolysis or photolysis of the ions of said at least two metals.

2. An image receiving material according to claim 1 wherein the greatest difference in metal composition between the nuclei in said image receiving layer is lower than 20%.

3. An image receiving material according to claim 1 or 2 wherein said other metal(s) have an E° value of at least - 0.4 V..

4. An image receiving material according to any of claims 1 to 3 wherein said physical development nuclei have a number average diameter of less than 8nm

5. An image receiving material according to any of claims 1 to 4 further comprising on said support a silver halide emulsion layer.

6. An image receiving material according to claim 5 wherein the image receiving layer is the outermost layer.

7. An image receiving material according to claim 5 wherein the surface of said support is hydrophilic and said image receiving layer is provided directly on said support.

8. A method for obtaining an image comprising the steps of information-wise exposing an imaging element comprising on a support a silver halide emulsion and developing said information-wise exposed imaging element in the presence of developing agent(s) and silver halide solvent(s) whilst in contact with a non-light sensitive image receiving material as defined in any of claims 1 to 4.

9. A method for obtaining a lithographic printing plate comprising the steps of information-wise exposing an imaging element as defined in claim 6 and subsequently developing said information-wise exposed imaging element in the presence of developing agent(s) and silver halide solvent(s).

10. A method for obtaining a lithographic printing plate comprising the steps of information-wise exposing an imaging element as defined in claim 9, subsequently developing said information-wise exposed imaging element in the presence of developing agent(s) and silver halide solvent(s) thereby forming a silver image in said image receiving layer and rinsing said developed imaging element with water to expose said silver image formed in said image receiving layer.

## Patentansprüche

1. Ein Bildempfangsmaterial, das auf einem Träger eine Bildempfangsschicht mit physikalischen Entwicklungskeimen enthält, wobei die Keime aus einer wesentlich homogenen festen Lösung von wenigstens zwei Metallen bestehen, von denen eines einen E°-Wert von wenigstens 0,75 V und das (die) andere(n) einen E°-Wert von wenigstens - 1 V aufweist (aufweisen), und die physikalischen Entwicklungskeime durch Radiolyse oder Fotolyse der Ionen der wenigstens zwei Metalle erzeugbar sind.

2. Bildempfangsmaterial nach Anspruch 1, dadurch gekennzeichnet, daß der größte Unterschied in Metallzusammensetzung zwischen den Keimen in der Bildempfangsschicht weniger als 20% beträgt.

3. Bildempfangsmaterial nach Anspruch 1 oder 2, dadurch gekennzeichnet, daß das (die) andere(n) Metall(e) einen E°-Wert von wenigstens - 0,4 V aufweist (aufweisen).

4. Bildempfangsmaterial nach irgendeinem der Ansprüche 1 bis 3, dadurch gekennzeichnet, daß die physikalischen Entwicklungskeime einen zahlendurchschnittlichen Durchmesser von weniger als 8 nm aufweisen.

5. Bildempfangsmaterial nach irgendeinem der Ansprüche 1 bis 4, das auf dem Träger weiterhin eine Silberhalogenid-Emulsionsschicht enthält.

6. Bildempfangsmaterial nach Anspruch 5, dadurch gekennzeichnet, das die Bildempfangsschicht die äußerste Schicht ist.

7. Bildempfangsmaterial nach Anspruch 5, dadurch gekennzeichnet, daß die Trägeroberfläche hydrophil ist und die Bildempfangsschicht direkt auf den Träger vergossen ist.

8. Verfahren zum Erhalt eines Bildes, das als Stufen die informationsmäßige Belichtung eines bilderzeugenden Elements, das auf einem Träger eine Silberhalogenid-Emulsionsschicht enthält, und anschließend die Entwicklung des informationsmäßig belichteten bilderzeugenden Elements in Kontakt mit einem lichtunempfindlichen, wie in irgendeinem der Ansprüche 1 bis 4 definierten Bildempfangsmaterial in Gegenwart einer oder mehrerer Entwicklersubstanzen und eines oder mehrerer Silberhalogenid-Lösungsmittel umfaßt.

9. Verfahren zum Erhalt einer lithografischen Druckplatte, das als Stufen die informationsmäßige Belichtung eines in Anspruch 6 definierten bilderzeugenden Elements und anschließend die Entwicklung des informationsmäßig belichteten bilderzeugenden Elements in Gegenwart einer oder mehrerer Entwicklersubstanzen und eines oder mehrerer Silberhalogenid-Lösungsmittel umfaßt.

10. Verfahren zum Erhalt einer lithografischen Druckplatte, das als Stufen die informationsmäßige Belichtung eines in Anspruch 9 definierten bilderzeugenden Elements, die Entwicklung des informationsmäßig belichteten bilderzeugenden Elements in Gegenwart einer oder mehrerer Entwicklersubstanzen und eines oder mehrerer Silberhalogenid-Lösungsmittel, wobei in der Bildemfangsschicht ein Silberbild erstellt wird, und die Spülung des entwickelten bilderzeugenden Elements mit Wasser, um das in der Bildempfangsschicht erstellte Silberbild freizulegen, umfaßt.

## Revendications

1. Un matériau récepteur d'image comprenant sur un support une couche réceptrice contenant des germes de développement physique, composée d'une solution solide substantiellement homogène d'au moins deux métaux, l'un deux possédant une valeur E° d'au moins 0,75 V, l'autre (les autres) possédant une valeur E° d'au moins - 1 V, caractérisé en ce que les germes de développement physique peuvent être obtenus par radiolyse ou photolyse des ions desdits deux ou plusieurs métaux.

2. Un matériau récepteur d'image selon la revendication 1, caractérisé en ce que la plus grande différence en composition métallique entre les germes dans la couche réceptrice d'image est inférieure à 20 %.

3. Un matériau récepteur d'image selon la revendication 1 ou 2, caractérisé en ce que l'autre (les autres) métal (métaux) a (ont) une valeur E° d'au moins - 0,4 V.

4. Un matériau récepteur d'image selon l'une quelconque des revendications 1 à 3, caractérisé en ce que les germes de développement physique ont un diamètre moyen en nombre inférieur à 8 nm.

5. Un matériau récepteur d'image selon l'une quelconque des revendications 1 à 4, comprenant en plus sur ledit support une couche d'émulsion à l'halogénure d'argent.

6. Un matériau récepteur d'image selon la revendication 5, caractérisé en ce que la couche réceptrice d'image est la couche située le plus à l'extérieur.

7. Un matériau récepteur d'image selon la revendication 5, caractérisé en ce que la surface dudit support est hydrophile et que ladite couche réceptrice d'image est fournie directement sur le support.

8. Un procédé pour obtenir une image, comprenant les phases consistant à exposer en forme d'informations un élément formateur d'image comprenant sur un support une émulsion à l'halogénure d'argent et à développer cet élément formateur d'image exposé en forme d'informations en présence d'un ou de plusieurs développateurs et d'un ou de plusieurs solvants de l'halogénure d'argent tandis qu'il est en contact avec un matériau récepteur d'image non sensible à la lumière tel que défini dans l'une quelconque des revendications 1 à 4.

9. Un procédé pour obtenir une plaque d'impression lithographique comprenant les phases consistant à exposer en forme d'informations un élément formateur d'image tel que défini à la revendication 6 et ensuite à développer cet élément formateur d'image exposé en forme d'informations en présence d'un ou de plusieurs développateurs et d'un ou de plusieurs solvants de l'halogénure d'argent.

10. Un procédé pour obtenir une plaque d'impression lithographique comprenant les phases consistant à exposer en forme d'informations un élément formateur d'image tel que défini à la revendication 9, ensuite à développer cet élément formateur d'image exposé en forme d'informations en présence d'un ou de plusieurs développateurs et d'un ou de plusieurs solvants de l'halogénure d'argent, formant ainsi une image argentique dans ladite couche réceptrice d'image, et à rincer l'élément formateur d'image développé avec de l'eau pour mettre à nu l'image argentique formée dans la couche réceptrice d'image.
